(19) **Europäisches Patentamt / European Patent Office / Office européen des brevets**

(11) **EP 3 420 636 B1**

(12) **FASCICULE DE BREVET EUROPEEN**

(45) Date de publication et mention de la délivrance du brevet:
**20.03.2024 Bulletin 2024/12**

(21) Numéro de dépôt: **17734772.1**

(22) Date de dépôt: **06.07.2017**

(51) Classification Internationale des Brevets (IPC):
**H03K 3/59** *(2006.01)* **F03H 1/00** *(2006.01)*

(52) Classification Coopérative des Brevets (CPC):
**H03K 3/59; F03H 1/0018;** F03H 1/0075

(86) Numéro de dépôt international:
**PCT/EP2017/066980**

(87) Numéro de publication internationale:
**WO 2018/007545 (11.01.2018 Gazette 2018/02)**

(54) **SYSTÈME D'ALIMENTATION ÉLECTRIQUE D'UN PROPULSEUR ÉLECTRIQUE À EFFET HALL**

STROMVERSORGUNGSSYSTEM FÜR EINE ELEKTRISCHES HALLEFFEKT-STRAHLRUDER

ELECTRIC POWER SUPPLY SYSTEM FOR A HALL EFFECT ELECTRIC THRUSTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.07.2016 FR 1656532**

(43) Date de publication de la demande:
**02.01.2019 Bulletin 2019/01**

(73) Titulaire: **Airbus Defence and Space SAS**
**31402 Toulouse Cedex 4 (FR)**

(72) Inventeurs:
• **BROTONS, Cyril**
**31402 Toulouse Cedex 4 (FR)**
• **LOUBERE, Dimitry**
**31402 Toulouse Cedex 4 (FR)**
• **SCREMIN, Guillaume**
**31402 Toulouse Cedex 4 (FR)**
• **GUILHEM-DUCLEON, Matthias**
**31402 Toulouse Cedex 4 (FR)**

(74) Mandataire: **Ipside**
**6, Impasse Michel Labrousse**
**31100 Toulouse (FR)**

(56) Documents cités:
**CN-A- 103 982 386    US-B1- 6 304 040**
**US-B2- 8 024 917**

**Description**

**Domaine de l'invention**

La présente invention appartient au domaine de la propulsion spatiale. Plus particulièrement, la présente invention concerne un propulseur électrique à effet Hall.

La présente invention porte notamment sur un système d'alimentation électrique d'un propulseur électrique à effet Hall.

**Etat de la technique**

Le fonctionnement d'un propulseur électrique à effet Hall et le rôle des divers éléments le composant, à savoir notamment une anode, une cathode, un circuit magnétique, et un dispositif de chauffage de la cathode, sont bien connus de l'homme du métier. A titre d'exemple, on peut citer « Fundamentals of Electric Propulsion: Ion and Hall Thrusters », Dan M. Goebel and Ira Katz, JPL SPACE SCIENCE AND TECHNOLOGY SERIES, Mars 2008. Ils ne sont que brièvement rappelés ici.

En régime établi, un plasma est formé au niveau de l'anode et de la cathode, et la propulsion est assurée par l'accélération électrostatique des ions positifs formés. Un gaz propulsif, généralement le xénon, injecté au niveau de l'anode et entrant en collision avec les électrons confinés au niveau de l'anode par un champ magnétique, assure le renouvellement du plasma.

Un propulseur électrique à effet Hall conventionnel est alimenté par un système d'alimentation électrique, communément dénommé PPU (de l'acronyme anglais « Power Processing Unit »).

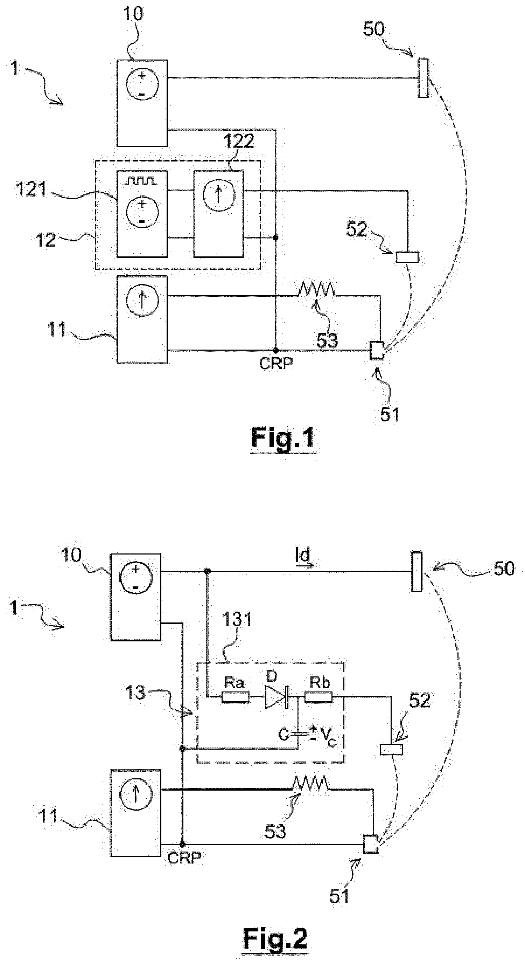

La figure 1 illustre un système d'alimentation électrique 1 classique d'un propulseur électrique à effet Hall.

Ce système d'alimentation électrique comporte typiquement des alimentations distinctes pour alimenter les différents éléments du propulseur électrique à effet Hall.

Sur la figure 1, les sources de tensions sont symbolisées par le sigle $\pm$ et les sources d'intensité de courant par le sigle T.

Le système d'alimentation électrique 1 comprend :

- une première source d'alimentation 10 destinée à alimenter l'anode 50,
- une deuxième source d'alimentation 11 destinée à alimenter le dispositif de chauffage 53 pour chauffer la cathode 51 et lui permettre d'émettre des électrons,
- un bloc d'alimentation 12 destiné à alimenter un élément proche de la partie émissive de la cathode, dénommé igniteur 52.

La première source d'alimentation 10 est une source de haute tension, continue, et fournit l'essentiel de l'énergie électrique nécessaire au fonctionnement du propulseur électrique à effet Hall.

La deuxième source d'alimentation 11 est une source de courant.

Le bloc d'alimentation 12 comprend un premier bloc, dit module d'allumage 121, combiné et commutable avec un second bloc, dit module de maintien 122. De manière générale, le module d'allumage 121 comporte un générateur de créneaux de tension, ou une source continue de haute tension, et le module de soutien 122 comporte une source de courant.

L'ensemble des première 10 et deuxième 11 sources d'alimentation et bloc d'alimentation 12 est relié à la cathode 51 qui est la référence de tension, communément dénommée CRP (de l'acronyme anglais « Cathode Reference Point »).

Pour atteindre le régime établi, un processus d'allumage complexe doit être mis en oeuvre.

La cathode 51 est préchauffée, généralement pendant quelques minutes, via le dispositif de chauffage 53. Simultanément à cette phase de chauffage, ou à la suite de celle-ci, une tension est appliquée entre l'igniteur 52 et la cathode 51. Un courant électrique très faible s'établit entre la cathode 51 et l'igniteur 52 facilité par l'effet thermoélectronique dû au chauffage de la cathode 51 par le dispositif de chauffage 53. La tension est appliquée jusqu'à ce qu'un plasma soit généré dans la cathode 51. Pour certaines technologies de cathode, une tension continue élevée de l'ordre de 100 à 500 V suffit. Pour d'autres technologies, la tension est appliquée sous la forme d'impulsions rectangulaires, comprise entre 0 et 100-500 V, typiquement chacune d'une durée de quelques ms à une fréquence de ~10Hz, ce qui augmente la fiabilité de l'allumage pendant toute la durée de vie du propulseur électrique à effet Hall. La tension sous la forme d'impulsions rectangulaires peut éventuellement être combinée à une tension continue comprise entre 50 à 150 V.

Lorsque le plasma est généré au niveau de la cathode 51, la conductivité électrique entre celle-ci et l'igniteur 52 est fortement augmentée si bien que l'intensité du courant circulant dans l'igniteur 52 augmente.

Un capteur électronique de contrôle détecte cette augmentation de courant et coupe alors le module d'allumage 121. Il peut également être envisagé que le capteur électronique de contrôle coupe automatiquement le module d'allumage 121 après une durée prédéfinie.

Dans une phase ultérieure, dénommée phase de soutien, le capteur électronique de contrôle applique à l'igniteur 52, via le module de soutien 122, une tension plus faible, sous une forme continue ou pulsée.

Cette phase de soutien, typiquement, dure jusqu'à ce qu'un courant de décharge apparaisse entre l'anode 50 et la cathode 51 et crée un plasma dans l'anode 50. Le propulseur électrique à effet Hall est alors allumé.

La gestion de l'alimentation de l'igniteur 52 se révèle très complexe (multiples sources d'alimentations, capteur électronique de contrôle, commutation d'un mode de fonctionnement à l'autre), ce qui contribue à l'augmentation du coût, du volume et de la masse du propulseur électrique à effet Hall et de ses alimentations électriques (PPU). En outre, le nombre et la complexité des appareils électroniques affectent la fiabilité dudit propulseur électrique à effet Hall, ce qui oblige à des surdimensionnements et/ou des redondances, amplifiant d'autant plus les coût, volume et masse. La PPU s'avère à ces égards la partie la plus critique de la propulsion électrique.

Le brevet US 8,024,917, par exemple, propose de simplifier la PPU, au niveau de l'unité d'alimentation électrique de l'igniteur, en utilisant une source d'alimentation commune, multifonctionnelle, alimentant le dispositif de chauffage, l'igniteur, l'anode et éventuellement le circuit magnétique de contrôle du plasma. Un commutateur est configuré pour couper l'alimentation du dispositif de chauffage au moyen d'un premier dispositif électronique. Lorsque le commutateur est en position fermée, la source d'alimentation commune alimente le dispositif de chauffage, et aucun courant ne traverse les deux autres circuits alimentant l'anode et l'igniteur. Puis, lorsqu'un critère prédéfini, par exemple une durée, une tension, une intensité de courant ou une température, est vérifié, le premier dispositif électronique bascule le commutateur en position ouverte, ce qui coupe en conséquence l'alimentation du dispositif de chauffage. La tension aux bornes de l'igniteur et de l'anode est alors égale à la tension en circuit ouvert de l'alimentation, typiquement 300V. La tension est suffisante pour qu'un courant de décharge apparaisse dans l'espace compris entre la cathode et l'igniteur. La tension entre la cathode et l'igniteur chute alors en dessous de la tension aux bornes de l'anode. Un flux d'électrons se crée et se dirigent de la cathode vers l'anode, qui est à une tension plus élevée, si bien qu'un courant de décharge s'établit entre la cathode et l'anode créant un plasma. Le propulseur électrique est alors allumé. L'ouverture d'un deuxième commutateur permet à un deuxième dispositif électronique de couper l'alimentation de l'igniteur.

L'alimentation électrique de l'igniteur reste cependant très complexe. On peut également citer le brevet US 6,304,040 qui décrit un système d'alimentation électrique d'un propulseur électrique à effet Hall. Une tension aux bornes de l'igniteur et de l'anode est générée sous la forme d'impulsions au moyen d'un commutateur géré par une commande logique jusqu'à ce qu'un courant de décharge apparaisse dans l'espace compris entre la cathode et l'igniteur. Le système d'alimentation s'avère également complexe et onéreux, notamment du fait de l'emploi d'une inductance.

Le document CN103982386 A décrit un système d'alimentation électrique d'un propulseur électrique à effet Hall.

## Exposé de l'invention

La présente invention a pour objectif de remédier à tout ou partie des limitations des solutions de l'art antérieur, notamment à celles exposées ci-avant, en proposant une solution simple et économique, tout en garantissant une fiabilité de l'allumage du propulseur électrique à effet Hall.

A cet effet, l'invention est définie par la revendication indépendante de système 1.

Un tel système d'alimentation électrique permet de simplifier l'alimentation de l'igniteur au moyen d'un circuit électrique passif, comportant uniquement des composants passifs classiques.

La tension générée entre l'igniteur et la cathode, sous la forme d'impulsions permet avantageusement d'améliorer la fiabilité de l'allumage du propulseur électrique à effet Hall.

Suivant des modes de réalisation préférés, l'invention répond en outre aux caractéristiques suivantes, mises en oeuvre séparément ou en chacune de leurs combinaisons techniquement opérantes.

Dans des modes particuliers de réalisation, le circuit électrique passif est configuré pour générer une tension sous la forme d'une série d'impulsions successives. Le circuit électrique passif génère de lui-même les impulsions successives, sans recourir à une commande extérieure.

Le circuit électrique passif ne comporte avantageusement pas d'inductance, composant présentant un poids conséquent par rapport à d'autres composants passifs, comme une résistance ou une capacité, et onéreux.

Dans des modes particuliers de réalisation, le circuit électrique passif comporte un condensateur. La charge et la décharge du condensateur forme respectivement un front montant et un front descendant d'une impulsion.

L'invention est également définie par la revendication indépendante de procédé 4.

Dans des modes particuliers de mise en oeuvre, le circuit électrique passif est configuré pour générer une tension sous la forme d'une série d'impulsions successives jusqu'à l'apparition d'un courant de décharge entre l'anode et la cathode.

Dans des modes particuliers de mise en oeuvre, le chauffage de la cathode est interrompu après la mise sous tension de l'anode et avant l'allumage du propulseur électrique, de sorte que l'amplitude maximale des impulsions augmente avec la diminution de l'émission des électrons par la cathode. L'extinction du chauffage de la cathode préalablement à l'allumage du propulseur permet également avantageusement d'utiliser la source d'alimentation destinée au chauffage de la cathode pour une autre application.

**Présentation des figures**

L'invention sera mieux comprise à la lecture de la description ci-après, donnée à titre d'exemple nullement limitatif, et faite en se référant aux figures ci-après qui représentent :

Figure 1, déjà décrite, un système d'alimentation électrique d'un propulseur électrique à effet Hall selon l'art antérieur,
Figure 2, un exemple de système d'alimentation électrique d'un propulseur électrique à effet Hall selon l'invention,
Figure 3a, une courbe illustrant un signal de tension aux bornes du condensateur,
Figure 3b, une courbe illustrant l'émission d'électrons par la cathode et du courant de décharge
Figure 4, une variante non revendiquée de système d'alimentation électrique d'un propulseur électrique à effet Hall.

Dans ces figures, des références identiques d'une figure à une autre désignent des éléments identiques ou analogues. Pour des raisons de clarté, les éléments représentés ne sont pas à l'échelle, sauf mention contraires.

**Description détaillée d'un mode de réalisation de l'invention**

La présente invention porte sur un système d'alimentation électrique 1 d'un propulseur électrique à effet Hall 1.

Un propulseur à effet Hall comporte, classiquement, d'une part un canal de décharge auquel est associée une anode 50, et d'autre part un ensemble cathode disposé au voisinage de la sortie du canal de décharge. L'ensemble cathode comporte une cathode 51 et un dispositif de chauffage 53 disposé à proximité de la cathode 51 et destiné à chauffer ladite cathode pour lui permettre d'émettre des électrons. Un circuit magnétique entoure le canal de décharge et crée au sein du canal de décharge un champ magnétique radial. Un gaz propulsif, par exemple du xénon, est injecté à l'arrière du canal de décharge et dans la cathode. Le gaz propulsif est ionisé dans le canal de décharge par collision avec les électrons émis par la cathode 51. L'ionisation du gaz propulsif génère un plasma. Les ions produits sont accélérés et éjectés à très haute vitesse (15 à 25 km/s) par un champ électrique axial créé entre l'anode et la cathode, afin de générer l'effet propulsif. Le champ électrique est généré par la combinaison du champ magnétique et d'une différence de potentiel électrostatique entre l'anode et la cathode.

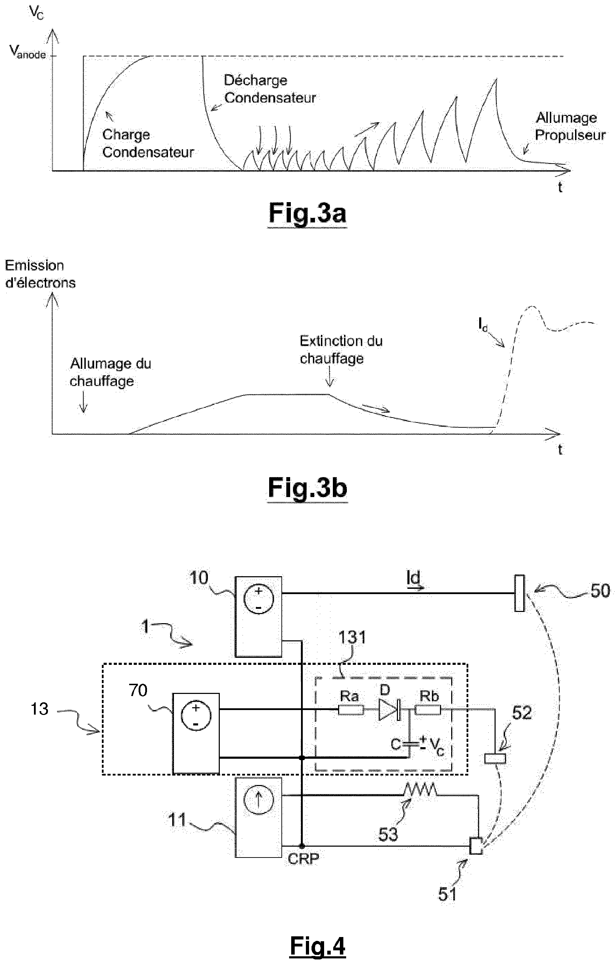

Sur la figure 4 est représenté un système d'alimentation électrique 1 du propulseur électrique à effet Hall, selon un mode de réalisation non revendiqué.

Le système d'alimentation électrique 1 comprend une première source d'alimentation 10 destinée à alimenter électriquement l'anode 50. Ladite première source d'alimentation est par exemple une source de haute tension, de préférence continue. Elle délivre une tension maximale $V_{anode}$.

Le système d'alimentation électrique 1 comprend une deuxième source d'alimentation 11 destinée à alimenter électriquement le dispositif de chauffage 53 pour chauffer la cathode 51 et lui permettre d'émettre des électrons. La deuxième source d'alimentation 11 est préférentiellement une source en courant.

Le système d'alimentation électrique 1 comprend une unité d'alimentation 13 destinée à alimenter électriquement un igniteur 52. Ladite unité d'alimentation comporte une source d'alimentation électrique, dite troisième source d'alimentation 70, et un circuit électrique passif 131. La troisième source d'alimentation 70 est par exemple une source de haute tension, de préférence continue.

Le circuit électrique passif 131 comporte une première résistance $R_a$, directement reliée à la troisième source d'alimentation 70, montée en série avec une diode D et un condensateur C. Une seconde résistance $R_b$ est montée entre, d'une part la diode D et le condensateur C, et d'autre part l'igniteur 52. Le condensateur C est relié, à son autre borne, au point de référence cathode CRP.

Le système d'alimentation électrique 1 peut comprendre une quatrième source d'alimentation destinée à alimenter électriquement le circuit magnétique. Le circuit magnétique et la quatrième source d'alimentation ne sont pas représentés sur la figure 4.

Dans un mode préféré de réalisation de l'invention, et comme illustré sur la figure 2, pour limiter le nombre de sources d'alimentation, la première source d'alimentation 10 et la troisième source d'alimentation 70 sont une seule et même source d'alimentation. Un tel mode de réalisation est préféré lorsque, selon le type de propulseur électrique choisi, la tension de fonctionnement du propulseur électrique est sensiblement égale à la tension nécessaire pour l'allumage dudit propulseur électrique. Le circuit électrique passif 131 comporte une première résistance $R_a$, directement reliée, ou au travers d'un interrupteur, à la première source d'alimentation 10, montée en série avec une diode D et un condensateur C. Une seconde résistance $R_b$ est montée entre, d'une part la diode D et le condensateur C, et d'autre part l'igniteur 52. Le condensateur C est relié, à son autre borne, au point de référence cathode CRP.

Le circuit électrique passif 131 est alimenté par la première source d'alimentation 10, ou la troisième source d'alimentation selon la configuration de la figure 2 ou 4 choisie, et est configuré pour générer, en sortie, une tension sous la forme d'au moins une impulsion.

La charge et la décharge du condensateur C forment respectivement un front montant et un front descendant d'une impulsion.

Le fonctionnement d'un tel circuit est à présent expliqué, en relation avec les courbes représentées aux figures 3a et 3b, pour permettre le démarrage du propulseur électrique à effet Hall.

La figure 3a illustre l'évolution au cours du temps du signal de tension $V_c$ aux bornes du condensateur C.

La figure 3b illustre l'évolution au cours du temps de l'émission d'électrons par la cathode (ligne continue) et du courant de décharge (en ligne discontinue).

Une première phase consiste en une phase de chauffage de la cathode 51.

Durant cette phase de chauffage, la cathode 51 est chauffée jusqu'à une température prédéfinie. La cathode 51 est chauffée au moyen du dispositif de chauffage 53 alimenté par la deuxième source d'alimentation 11.

La cathode 51 est chauffée jusqu'à ce qu'elle atteigne une température correspondant à la température minimum permettant l'émission par la cathode 51 d'une quantité d'électrons nécessaire à l'établissement dans le canal de décharge d'un courant de décharge suffisant pour ioniser des atomes du gaz propulsif dans ledit canal de décharge.

Dans un exemple de mise en oeuvre, lorsque le matériau de la cathode 51 est en héxaborure de lanthane (LaB6), la température est de l'ordre de 1600 °C.

Dans une deuxième phase, une tension continue est appliquée entre l'anode 50 et la cathode 51, via la première source d'alimentation 10.

Dans la configuration où la première source d'alimentation 10 est commune à l'anode 50 et l'igniteur 52, une tension sous la forme d'au moins une impulsion est appliquée entre l'igniteur 52 et la cathode 51, via la première source d'alimentation et le circuit électrique passif.

Dans la configuration où les première et troisième sources d'alimentation sont distinctes, une tension sous la forme d'au moins une impulsion est appliquée entre l'igniteur 52 et la cathode 51, via la troisième source d'alimentation et le circuit électrique passif.

Cette deuxième phase est préférentiellement réalisée simultanément à la première phase, mais peut être réalisée à la suite de celle-ci, sans modifier le résultat desdites phases.

En parallèle de cette deuxième phase, une tension est appliquée aux bornes du circuit magnétique et un gaz propulsif est injecté à travers l'anode.

Dès que le condensateur C est alimenté par la première source d'alimentation 10, ou troisième source d'alimentation 70 selon la configuration de la figure 2 ou 4 employée, ledit condensateur C se charge avec une constante de temps $R_aC$ jusqu'à une tension à ses bornes proche de la tension $V_{anode}$ de l'anode. Un état stationnaire électrique s'établit jusqu'à ce que la cathode 51 atteigne un niveau d'émission d'électrons suffisant.

A ce moment là, un premier courant de décharge apparait entre l'igniteur et la cathode, déchargeant le condensateur C.

Comme dans l'art antérieur, un courant de décharge apparait lorsque la tension aux bornes de l'igniteur 52 est proche de la tension aux bornes de l'anode 50. Dans l'invention, la présence du condensateur C introduit un retard à la création de la tension aux bornes de l'igniteur 52. Ce retard dépend de la constante de temps du circuit et donc du choix de la première résistance $R_a$ et du condensateur C.

Puis une série d'impulsions se produit. Chaque impulsion commence par une charge partielle du condensateur C, suivie par une décharge de celui-ci chaque fois qu'un courant de décharge apparait entre l'igniteur 52 et la cathode 51. Le pic de chaque impulsion est alors bien inférieur à la tension $V_{anode}$, du aux décharges prématurées du condensateur C.

Les impulsions, c'est-à-dire les charges/décharges du condensateur, se succèdent jusqu'à ce qu'un courant de décharge $I_d$ entre l'anode 50 et la cathode 51 apparaisse. A ce moment là, un plasma est établi dans l'anode 50, permettant l'allumage du propulseur électrique à effet Hall.

L'établissement du plasma dans l'anode 50 peut se produire au cours d'une décharge quelconque du condensateur, même au cours la première décharge.

Dans un mode préféré de mise en oeuvre, pour améliorer la fiabilité de l'allumage de l'anode 50, il est préférable que la tension aux bornes du condensateur C, à l'issue de la charge de celui-ci, soit suffisamment élevée pour que l'énergie de décharge dudit condensateur soit suffisamment importante et propre à créer un courant de décharge $I_d$ entre l'anode 50 et la cathode 51.

Dans un exemple de mise en oeuvre, pour accumuler davantage d'énergie au niveau du condensateur C, la deuxième source d'alimentation 11 est interrompue de sorte à couper le chauffage de la cathode 51.

L'arrêt du chauffage de la cathode 51 a pour effet de réduire progressivement l'émission des électrons par la cathode 51 et par conséquent de réduire la probabilité d'apparition d'un courant de décharge entre l'igniteur et la cathode à basse tension. Ainsi, l'amplitude maximale des impulsions augmente avec la diminution de l'émission des électrons par la cathode 51. Ces amplitudes maximales augmentent jusqu'à ce que l'énergie libérée lors de la décharge du condensateur soit suffisante pour déclencher un courant de décharge $I_d$ entre l'anode 50 et la cathode 51 établissant un plasma au niveau de l'anode, permettant l'allumage du propulseur électrique à effet Hall.

Lorsque le plasma est présent dans le propulseur électrique à effet Hall, au niveau de l'anode et de la cathode, la conductivité électrique entre l'igniteur et la cathode est très élevée. La résistance $R_a$ permet alors de limiter le courant circulant depuis la première source d'alimentation 10, ou troisième source d'alimentation 70 selon la configuration de la figure 2 ou 4 employée, vers l'igniteur 52. Le condensateur C conserve, à ces bornes, une tension basse, drainant un faible courant à travers la résistance $R_b$, avec un effet négligeable sur le rendement du propulseur électrique à effet Hall. Un dispositif de coupure de l'alimentation de l'igniteur 52 n'est donc nécessaire car l'effet sur le rendement du moteur est aussi négligeable.

La diode D assure quant à elle une protection supplémentaire de l'anode et de la première alimentation électrique en cas de surtension au niveau du condensateur par rapport à l'anode.

L'ensemble troisième, ou première selon la configuration choisie, source d'alimentation et circuit électrique passif décrits ci-dessus remplace avantageusement le module d'allumage et le module de maintien équipant les propulseurs électriques à effet Hall de l'état de l'art.

Le dimensionnement des composants passifs $R_a$, $R_b$ et C se fait par des méthodes classiques de l'homme de l'art pour les électroniques spatiales, en fonction notamment des caractéristiques du propulseur électrique à effet Hall, notamment la technologie de l'émetteur sur la cathode, son comportement thermique et thermoélectronique, les caractéristiques de l'alimentation de l'anode telles que le maximum de courant acceptable. Cela détermine aussi les amplitudes maximales des impulsions, et le courant résiduel en fonctionnement continu après l'allumage du propulseur électrique à effet Hall.

Dans un exemple de réalisation, on choisira $R_a \gg R_b$.

$R_a$ doit être préférentiellement suffisamment grand pour protéger la première source d'alimentation 10, ou la troisième source d'alimentation 70 selon la configuration de la figure 2 ou 4 choisie, contre un courant instantané trop élevé dans la phase avant l'allumage du propulseur électrique à effet Hall et pour avoir un courant résiduel faible, aux bornes du condensateur, après allumage du propulseur électrique à effet Hall.

$R_b$ est préférentiellement relativement faible pour permettre une décharge rapide du condensateur C pendant la phase d'allumage, avant l'allumage du propulseur électrique à effet Hall, ce qui permet de passer plus d'énergie durant cette phase.

Dans le cas particulier d'un propulseur électrique à effet Hall de type SPT 100, des essais concluants ont été menés avec les valeurs suivantes :

$$R_a =\sim 200 \text{ kOhm} \; ; \; R_b =\sim 100 \text{ Ohm} \; ; \; C =\sim 1\mu F$$

Après une phase de chauffage de la cathode de l'ordre de 160s, l'anode a été mise sous tension (300 V). Simultanément le chauffage de la cathode a été coupé. La première décharge entre la cathode et l'igniteur s'est déclenchée au bout d'une seconde. La décharge au niveau de l'anode s'est déclenchée 15 secondes après, suite à l'émission d'impulsions croissantes entre l'igniteur et la cathode.

## Revendications

1. Système d'alimentation électrique (1) d'un propulseur électrique à effet Hall, ledit propulseur électrique à effet Hall comprenant une anode (50), une cathode (51), un dispositif de chauffage (53) pour la cathode, un igniteur (52), ledit système d'alimentation électrique comportant :

   - une première source d'alimentation (10) destinée à alimenter l'anode (50), ladite première source d'alimentation comportant une première borne reliée à l'anode et une deuxième borne reliée au point de référence cathode (CRP),
   - une deuxième source d'alimentation (11) destinée à alimenter le dispositif de chauffage (53),
   - une unité d'alimentation (13) destinée à alimenter électriquement l'igniteur (52),

   **caractérisé en ce que** l'unité d'alimentation (13) comporte un circuit électrique passif (131) électriquement connecté entre la première borne et la seconde borne de la première source d'alimentation, ledit circuit électrique passif étant alimenté par ladite première source d'alimentation et configuré pour générer une tension, entre l'igniteur et la cathode, inférieure ou égale à une tension continue délivrée par ladite première source d'alimentation, sous la forme d'au moins une impulsion, ladite tension générant l'apparition d'un courant de décharge entre l'igniteur et la cathode.

2. Système d'alimentation électrique (1) selon la revendication 1 dans lequel le circuit électrique passif est configuré pour générer une tension sous la forme d'une série d'impulsions successives.

3. Système d'alimentation électrique (1) selon l'une des revendications précédentes dans lequel le circuit électrique passif (131) comporte un condensateur.

4. Procédé pour démarrer un propulseur électrique à effet Hall à partir du système d'alimentation électrique (1) conforme à l'une des revendications 1 à 3, ledit procédé comportant les étapes de :

- chauffage de la cathode (51) par le dispositif de chauffage (53) jusqu'à une température prédéfinie nécessaire pour permettre l'émission d'électrons par ladite cathode,
- application d'une tension continue entre l'anode (50) et la cathode (51),
- génération, par le circuit électrique passif (131), d'une tension entre l'igniteur (52) et la cathode (51), inférieure ou égale à la tension continue délivrée par la première source d'alimentation, sous la forme d'au moins une impulsion.

5. Procédé selon la revendication 4 dans lequel la tension entre l'igniteur (52) et la cathode (51) est générée sous la forme d'une série d'impulsions successives, jusqu'à l'apparition d'un courant de décharge entre l'anode et la cathode.

**Patentansprüche**

1. Stromversorgungssystem (1) eines elektrischen Hall-Effekt-Antriebs, wobei der elektrische Hall-Effekt-Antrieb eine Anode (50), eine Kathode (51), eine Heizvorrichtung (53) für die Kathode und einen Zünder (52) umfasst, wobei das Stromversorgungssystem beinhaltet:

- eine erste Versorgungsquelle (10), die bestimmt ist, um die Anode (50) zu versorgen, wobei die erste Versorgungsquelle eine erste Klemme beinhaltet, die an die Anode angeschlossen ist, und eine zweite Klemme, die an den Kathodenreferenzpunkt (CRP) angeschlossen ist,
- eine zweite Versorgungsquelle (11), die bestimmt ist, um die Heizvorrichtung (53) zu versorgen,
- eine Versorgungseinheit (13), die bestimmt ist, um den Zünder (52) elektrisch zu versorgen,

**dadurch gekennzeichnet, dass** die Versorgungseinheit (13) einen passiven elektrischen Schaltkreis (131) beinhaltet, der elektrisch zwischen der ersten Klemme und der zweiten Klemme der ersten Versorgungsquelle verbunden ist, wobei der passive elektrische Schaltkreis von der ersten Versorgungsquelle versorgt wird und konfiguriert ist, um zwischen dem Zünder und der Kathode eine Spannung zu erzeugen, die kleiner oder gleich einer Gleichspannung ist, die von der ersten Versorgungsquelle in Form von mindestens einem Impuls geliefert wird, wobei die Spannung das Auftreten eines Entladestroms zwischen dem Zünder und der Kathode bewirkt.

2. Stromversorgungssystem (1) nach Anspruch 1, wobei der passive elektrische Schaltkreis konfiguriert ist, um eine Spannung in Form einer Reihe aufeinanderfolgender Impulse zu erzeugen.

3. Stromversorgungssystem (1) nach einem der vorhergehenden Ansprüche, wobei der passive elektrische Schaltkreis (131) einen Kondensator beinhaltet.

4. Verfahren zum Starten eines elektrischen Hall-Effekt-Antriebs ausgehend vom Stromversorgungssystem (1) nach einem der Ansprüche 1 bis 3, wobei das Verfahren die Schritte beinhaltet:

- Erhitzen der Kathode (51) durch die Heizvorrichtung (53) bis auf eine vordefinierte Temperatur, die erforderlich ist, um die Emission von Elektronen durch die Kathode zu ermöglichen,
- Anlegen einer Gleichspannung zwischen der Anode (50) und der Kathode (51),
- Erzeugen einer Spannung, durch den passiven elektrischen Schaltkreis (131), zwischen dem Zünder (52) und der Kathode (51), die kleiner oder gleich der Gleichspannung ist, die von der ersten Versorgungsquelle in Form von mindestens einem Impuls geliefert wird.

5. Verfahren nach Anspruch 4, wobei die Spannung zwischen dem Zünder (52) und der Kathode (51) in Form einer Reihe aufeinanderfolgender Impulse erzeugt wird, bis zum Auftreten eines Entladestrom zwischen der Anode und der Kathode.

**Claims**

1. Electric power supply system (1) of a Hall-effect electric thruster, said Hall-effect electric thruster comprising an anode (50), a cathode (51), a heater (53) for the cathode, an igniter (52), said electric power supply system comprising:

   - a first power supply source (10) for powering the anode (50), said first power supply source comprising a first terminal connected to the anode and a second terminal connected to the cathode reference point (CRP),
   - a second power supply source (11) for powering the heater (53),
   - a power supply unit (13) for electrically powering the igniter (52),

   **characterized in that** the power supply unit (13) comprises a passive electrical circuit (131) electrically connected between the first terminal and the second terminal of first power supply source, said passive electrical circuit being powered by said first power supply source and configured to generate a voltage, between the igniter and the cathode, less than or equal to a direct voltage provided by said first power supply source, in the form of at least one pulse, said voltage generating a discharge current between the igniter and the cathode.

2. Electric power supply system (1) as claimed in claim 1 wherein the passive electrical circuit is configured to generate a voltage in the form of a series of successive pulses.

3. Electric power supply system (1) as claimed in any of the preceding claims wherein the passive electrical circuit (131) comprises a capacitor.

4. Method for starting a Hall-effect electric thruster using the electric power supply system (1) as claimed in one of the claims 1 to 3, said method comprising the steps of:

   - heating the cathode (51) by the heater (53) to a predetermined temperature required to enable the emission of electrons by said cathode,
   - applying a direct voltage between the anode (50) and the cathode (51),
   - generating, by the passive electrical circuit (131), a voltage between the igniter (52) and the cathode (51), less than or equal to the direct voltage provided by the first power supply source, in the form of at least one pulse.

5. A method as claimed in claim 4 wherein the voltage between the igniter (52) and the cathode (51) is generated in the form of a series of successive pulses, until a discharge current appears between the anode and the cathode.

**Fig.1**

**Fig.2**

**Fig.3a**

**Fig.3b**

**Fig.4**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 8024917 B
- US 6304040 B
- CN 103982386 A

**Littérature non-brevet citée dans la description**

- **DAN M. GOEBEL ; IRA KATZ.** Fundamentals of Electric Propulsion: Ion and Hall Thrusters. *JPL SPACE SCIENCE AND TECHNOLOGY SERIES,* Mars 2008